Europäisches Patentamt

European Patent Office

Office européen des brevets

(19)

(11) Publication number: 0 199 685
A2

# EUROPEAN PATENT APPLICATION

(21) Application number: 86850043.0

(22) Date of filing: 12.02.86

(51) Int. Cl.4 G03F 7/12 . G03C 5/40

(30) Priority: 28.03.85 SE 8501546

(43) Date of publication of application:
29.10.86 Bulletin 86/44

(84) Designated Contracting States:
BE CH DE FR GB IT LI SE

(71) Applicant: Jemseby, Bo Wilhelm
Ledungsvägen 44
S-183 42 Täby(SE)

(72) Inventor: Jemseby, Bo Wilhelm
Ledungsvägen 44
S-183 42 Täby(SE)

(74) Representative: Nordén, Ake et al
AWAPATENT AB Box 7402
S-103 91 Stockholm(SE)

(54) A method of forming a stencil for screen printing machines.

(57) The invention provides a method of forming a stencil for screen printing machines, comprising a screen (3) stretched in a frame and a layer (11a, 11b, 11c) affixed to said screen and provided with a printing pattern, by exposing a light-sensitive film - (10) which comprises a light-sensitive layer (11) applied to a layer substrate (12), with an image corresponding to said printing pattern and then developing the light-sensitive layer of the exposed light-sensitive film, thereby to produce dark portions corresponding to portions illuminated during the exposure, said method being characterised in

(a) that the said dark portions are removed by an etching or bleaching process from the layer (11), thus leaving the substrate bare (5c, 6c) to form the pattern to be printed, the remaining layer (11a, 11b, 11c) forming margin lines against the desired printing pattern;

(b) that the said substrate (12) with the remaining unetched or unbleached layer, in order to form margin lines against the desired printing pattern, is placed against the screen - (3) stretched in the frame, such that the said remaining layer is caused to interact with the screen;

(c) that, after said interaction between the

remaining layer (11a, 11b, 11c) and the screen (3) has been established, only the substrate (12) is removed; and

(d) that a stencil intended for screen printing machines and provided with a layer having a printing pattern is formed.

Fig. 8

EP 0 199 685 A2

# A METHOD OF FORMING A STENCIL FOR SCREEN PRINTING MACHINES

## BACKGROUND OF THE INVENTION

The present invention relates to a method of forming a stencil for screen printing machines. especially a stencil comprising a screen stretched in a frame and a layer affixed to said screen and provided with a printing pattern. by causing a light-sensitive film comprising a light-sensitive layer applied to a layer substrate to be exposed with an image corresponding to the printing pattern, and then causing the light-sensitive layer of the exposed light-sensitive film to be developed, thereby to produce dark portions corresponding to portions illuminated during exposure.

## PRIOR ART

In principle, there exist today two different methods of producing a screen printing machine stencil comprising a screen stretched in a frame and a layer affixed to the screen and provided with a printing pattern. One of these methods is the "indirect screen printing method" and the other method is the "direct screen printing method".

The "indirect screen printing method" utilises a film, a so-called stencil film, which comprises a substrate and a light-sensitive material or emulsion . applied thereto. The film is treated with light from high-efficiency lamps via a positive film with a pattern which is equivalent to the pattern to be printed. By this light-treatment, the pattern of the positive film is transferred to the stencil film.

The film is then hung up and rinsed and flushed with water to make the pattern appear, the resulting product being termed "stencil". After that, the stencil is placed or rolled out on a screen previously stretched in a frame with the light-treated emulsion facing the screen, which means that the substrate will be facing away from the screen. The stencil which thus is pressed into the screen, is slightly dried, whereupon the substrate can be removed by so-called stripping. The emulsion proper, with the desired printing pattern formed therein, has now stuck fast in the screen and is further dried.

A stencil made in this manner may preferably be used for inks on a petroleum base, i.e. thinner and the like.

From an indirect stencil thus produced, the emulsion can be rinsed off by spraying it with water and/or hydrogen peroxide, and the frame and the screen stretched therein may be used again in a screen printing machine for other or similar patterns.

The "direct screen printing method" utilises a screen previously stretched in a frame and coated with a light-sensitive emulsion. usually of a different character than the one mentioned above. The light-sensitive emulsion is illuminated, via a pattern. with high-efficiency lamps, and the emulsion is hardened in those portions where high-luminous radiation has occurred. Usually, a positive film is employed, and its pattern is then transferred to the screen and the emulsion coated thereon. The screen is then rinsed and flushed with water and/or hydrogen peroxide to make the pattern appear, whereupon drying is effected.

A stencil produced in accordance with the direct screen printing method may be used not only for inks on a petroleum base, but also for inks on a water base.

This in turn implies that the emulsion utilised in the production of direct stencils is difficult to remove and cannot be removed merely by spraying it with water.

It is also known that the indirect screen printing method has proved to be superior to the direct screen printing method for printing work where high sharpness and correct reproduction of fine screen lines are required. Furthermore, it should be mentioned that the indirect screen printing method is being used especially in the production of multicolour screen printing. The direct screen printing method is used especially for water-based inks.

## DESCRIPTION OF THE INVENTION

### The technical problem

Since the production or formation of a stencil for screen printing machines has been carried out for a number of years according to the "indirect screen printing method" or the "direct screen printing method", it must be regarded as a highly sophisticated technical problem to be able to conceive an alternative method and, in addition, to establish the premises for giving an indication of certain simplifications connected with said screen printing methods.

Furthermore, it must be regarded as a technical problem to establish such premises that the film can be treated with light from low-efficiency lamps and still to establish the premises for a light-treatment of short duration, and for a sufficiently full exposure of the light-sensitive layer applied to a layer substrate which constitutes the light-sensitive film.

In relation to the "indirect screen printing method", it must be regarded as a technical problem to be able to establish such premises that the complete production of the screen film can be eliminated. as well as the premises for more directly making a light-sensitive film interact with a screen stretched in a frame. in that a light-treated and merely developed film can be made to interact with the screen.

Furthermore, it must be regarded as a technical problem to establish, in connection with the "direct screen printing method", such premises that the light-sensitive emulsion can be replaced by a far more light-sensitive emulsion and that, in this manner, light radiating lamps of low efficiency can be selected, while still establishing the premises for a short exposure time.

It must also be regarded as a sophisticated technical problem to be able to devise a method of forming a stencil for screen printing machines, in which a stencil thus produced gives a print satisfying great demands on sharpness and correct reproduction of fine screen lines.

It also is a technical problem to establish such premises that a stencil for screen printing machines can be made with such precision that the stencil can be used with great advantage in the production of multi-colour screen prints.

Finally, it must be regarded as a technical problem to be able to devise a stencil for screen printing machines which can be used both for inks based on petroleum and for inks based on water.

It is a further technical problem to provide a stencil for screen printing machines, in which the light-sensitive material or the emulsion not removed by etching or bleaching can be processed to form a reinforcement of the stencil screen.

The solution

The present invention now proposes a method of forming a stencil for screen printing machines, said stencil comprising a screen stretched in a frame and a layer affixed to said screen and provided with a pattern to be printed, by exposing a light-sensitive film which consists of a light-sensitive layer applied to a layer substrate, with an image corresponding to the printing pattern, and then developing the light-sensitive layer of the exposed light-sensitive film, thereby to form dark portions corresponding to the portions illuminated during the exposure.

In such a method, the present invention proposes removing the said dark portions by means of an etching or bleaching process from the layer to leave the layer substrate exposed to form the printing pattern. the remaining layer forming margin lines against the desired printing pattern.

Futhermore. in order to form margin lines against the desired printing pattern. the said substrate with the remaining unetched or unbleached layer is placed against the screen stretched in the frame, such that the said remaining layer can be made to interact with the screen, when the said layer has a gel-like consistency.

Furthermore, the present invention proposes that, after the said interaction between the remaining layer and the screen has been established. the remaining layer is slightly dried and made to stick against the screen, such that only the substrate can be removed.

In this manner. there is formed in the screen a stencil intended for screen printing machines and provided with a layer carrying the desired printing pattern.

The invention also includes the possibility of developing the remaining layer applied to the screen, in which case development should be effected after the said dark portions have been removed by etching or bleaching.

In addition, the invention proposes that the said etching or bleaching be carried out by treating at least the dark film portions with a solution of, for instance, sulphuric acid and potassium dichromate.

In particular, the present invention proposes that the light-sensitive layer be selected as a layer of high light sensitivity, such that processing and production must be carried out in a dark-room or under a red lamp, whereby the exposure time can be substantially reduced as compared to prior art methods.

Lastly, the present invention proposes that the light-sensitive layer be selected among gelatin and silver salts having a thickness exceeding 0.2 mm.

Advantages

The advantages primarily characteristic of a method according to the present invention, to form a stencil for screen printing machines, reside in that there have been established in this manner the premises for being able to produce the stencil with a short exposure time. while at the same time the formerly indispensable fixation of the image could be eliminated.

The primary characteristic features of a method according to the present invention are defined in the characterising clause of the appended claim 1.

## BRIEF DESCRIPTION OF THE DRAWINGS

A method of forming a stencil for screen printing machines, in accordance with the present invention, will now be described in more detail below. reference being had to the accompanying drawings in which

Fig. 1 is a side view of a light-sensitive film under exposure. for transferring an image on an original to a light-sensitive layer;

Fig. 2 shows the light-sensitive layer of the light-sensitive film after development;

Fig. 3 is an example of a film thus developed;

Fig. 4 shows the light-sensitive film after the dark portions obtained by the development have been removed by etching or bleaching;

Fig. 5 shows an example of an image thus developed, on which the remaining portions have been blacked out to make them more conspicuous;

Fig. 6 shows the light-sensitive layer of the light-sensitive film applied to a screen stretched in a frame;

Fig. 7 shows that, after interaction of the remaining layer and the screen, only the substrate of the light-sensitive film is removed; and

Fig. 8 shows a side view of a stencil made in accordance with the invention.

## DESCRIPTION OF AN EMBODIMENT OF THE INVENTION

The present invention relates to a method of forming a stencil 1, shown in Fig. 8, for a screen printing machine. The stencil comprises a screen 3 stretched in a frame 2, 2a and a layer 4 affixed to said screen 3 and provided with a pattern to be printed (alternative layers are 11a, 11b and 11c).

In Fig. 8, the printing pattern 5, 6 is illustrated merely as a free passage through the stencil screen 3 of an ink placed on the stencil 1 and applied thereto by means of a squeegee (not shown).

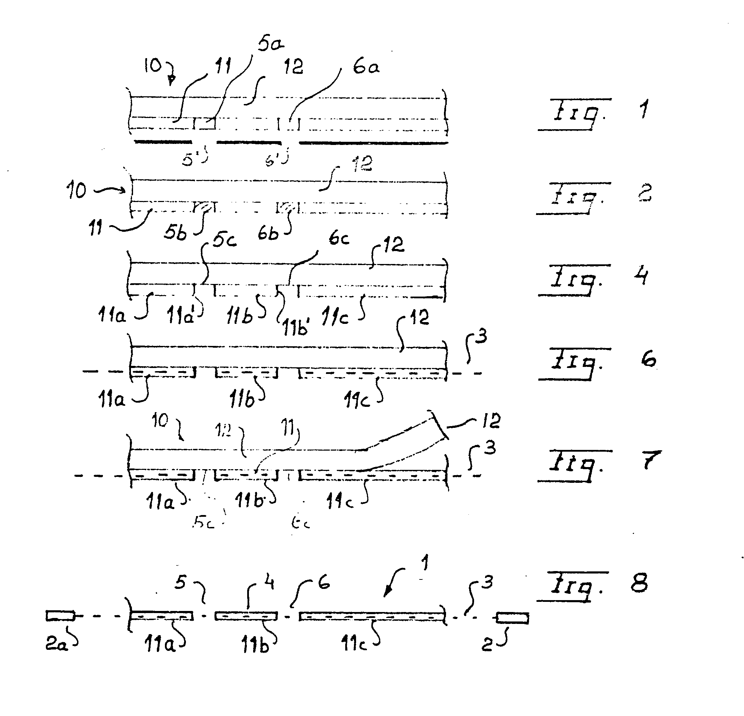

Fig. 1 illustrates a light-sensitive film 10 comprising a light-sensitive layer 11 applied to a layer substrate 12, said light-sensitive film being exposed with an image corresponding to the printing pattern 5', 6', or for transferring an original 5'. 6' to said light-sensitive layer 11. This is normally done by loading the light-sensitive film in a camera (not shown).

According to the present invention. the light-sensitive layer 11 of the light-sensitive film 10 thus exposed is developed, thereby to produce dark portions 5b, 6b corresponding to portions 5a, 6a illuminated during exposure. The invention proposes especially removing the said dark portions 5b, 6b by etching or bleaching from the layer 11, thus leaving the substrate 12 bare at positions 5c and 6c, thereby to form the pattern to be printed. In this manner, the remaining layers 11a, 11b and 11c will form, for example at positions 11a' and 11b', margin lines against the desired printing pattern.

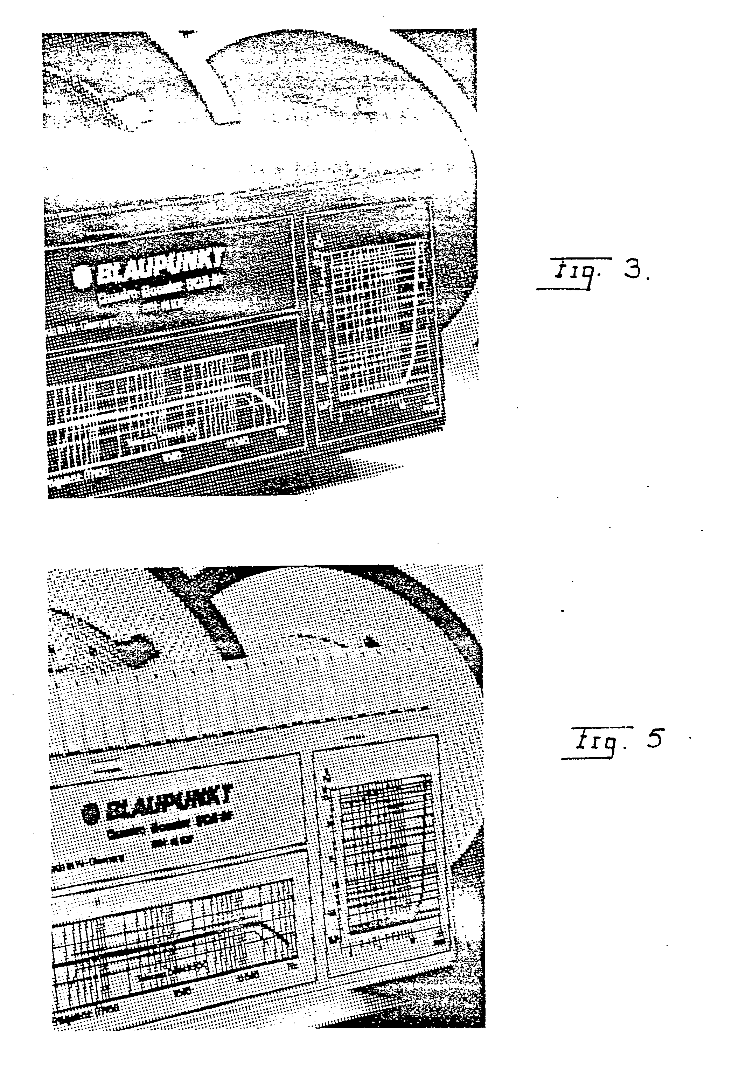

Fig. 5 shows an example of such an image on which the remaining portions have been blacked out to make them more conspicuous.

Fig. 6 shows how the substrate with the remaining unetched or unbleached layer 11a, 11b and 11c, respectively, to form margin lines against the desired printing pattern, is placed against the screen stretched in the frame, thereby to make the remaining layers 11a, 11b and 11c interact with the screen 3.

To this end, the remaining layer 11a, 11b and 11c, respectively, must have a slightly gel-like consistency.

After the said interaction between the remaining layers 11a, 11b and 11c, respectively, and the screen 3 has been established, and after the remaining layer has been slightly dried, it is possible to remove only the substrate 12, and this is done by stripping the substrate 12 off the remaining layers 11a, 11b and 11c, respectively.

In this manner, the stencil 1 for the screen printing machine is formed with a layer 11a, 11b and 11c, respectively, serving to define the printing pattern 5, 6.

It also lies within the scope of the invention that the remaining layer applied to the screen can be further developed, in which case it is suggested that development be carried out after the dark portions have been removed by etching or bleaching.

The etching or bleaching operation is carried out by treating at least the dark portions of the film with, for instance, a solution consisting of 5 g copper dichromate and 5 cc concentrated sulphuric acid diluted with one litre of water.

The bare portions 5c and 6c may be further cleaned by a mixture of glacial acetic acid, copper chloride and hydrogen peroxide. This bath may also be used as the only bleaching bath, instead of the one mentioned above.

It is especially directed that the light-sensitive layer 11 be a layer of high light sensitivity, such that processing and production must occur in a dark-room or under a red lamp, thereby to establish the premises for a reduced exposure time. Such light-sensitive layers are known in the art and utilised on film for conventional photography.

Furthermore, it is suggested that the light-sensitive layer 11 be selected among gelatin and silver salts having a thickness exceeding 0.2 mm, although this thickness must obviously be chosen with due regard to the screen material and only be so thick that the remaining layer will unfailingly seal any pores formed in the screen. It is suggested that the thickness should not exceed 0.5 mm.

Finally, the further development of the remaining layer also serves to increase the wear resistance of the stencil.

The invention will be further illustrated by the following nonrestrictive Example.

EXAMPLE

The film employed must have high light sensitivity, type lith film hardness, a thick. emulsion layer between 0.2 and 0.5 mm, and a consistency such that it can be partially pressed into the screen and get stuck therein. Furthermore, its attachment to the substrate should be as light as possible so that the substrate can be easily stripped off.

A negative is exposed in a camera or an enlarger via a lens. Suitable enlargement 3-10. The negative is exposed to a positive.

The exposed film is developed by high-constrast lith development, type rapid access or the like. It is important that the film be fully developed. The developed film is now positive, and the future print image is black.

The film is placed or hung in a bleaching bath, and after two minutes white light may be switched on. The bleaching bath can contain the following components: Glacial acetic acid + copper chloride (solution A), 30% hydrogen peroxide (solution B). The bleaching bath may consist of 1 part A + 1 part B + 4 parts of water.

After about 3 minutes. the black portions on the film are dissolved. Dissolution may be accelerated by douching or spraying, or by careful washing with the bleaching bath solution. Any residues of the black portions can be etched away in an etching bath of the type potassium ferricyanide (red potassium prussiate) and sodium thiosulfate (Hypo) or the like. The black portions should then have disappeared completely. and the layer should be clean so that the substrate will be entirely free. Also the remaining layer has now been illuminated and can be developed to produce a sharp image.

The processed film is then transferred to the screen in per se known manner, for example by pressing or mangling. Those parts of the film layer which have not been bleached away now constitute a stencil that stops the ink to be pressed through the screen by the squeegee after the substrate has been stripped off.

The invention is, of course, not restricted to the embodiment exemplified above, but may be modified in several ways within the scope of the invention as defined by the appended claims.

**Claims**

1. A method of forming a stencil for screen printing machines, comprising a screen stretched in a frame and a layer affixed to said screen and provided with a printing pattern, by exposing a light-sensitive film which comprises a light-sensitive layer applied to a layer substrate, with an image corresponding to said printing pattern and then developing the light-sensitive layer of the exposed light-sensitive film, thereby to produce dark portions corresponding to portions illuminated during the exposure, said method being **characterised** in

(a) that the said dark portions are removed by an etching or bleaching process from the layer, thus leaving the substrate bare to form the pattern to be printed, the remaining layer forming margin lines against the desired printing pattern;

(b) that the said substrate with the remaining unetched or unbleached layer, in order to form margin lines against the desired printing pattern, is placed against the screen stretched in the frame, such that the said remaining layer is caused to interact with the screen;

(c) that, after said interaction between the remaining layer and the screen has been established, only the substrate is removed; and

(d) that a stencil intended for screen printing machines and provided with a layer having a printing pattern is formed.

2. A method as claimed in claim 1, **characterised** by developing the remaining layer applied to the screen.

3. A method as claimed in claim 1, **characterised** by developing the remaining layer between steps "a" and "b".

4. A method as claimed in claim 1, **characterised** by carrying out the etching or bleaching process of step "a" by treating at least the dark film portions with a solution of sulphuric acid and potassium dichromate.

5. A method as claimed in claim 1, **characterised** by selecting for the light-sensitive layer a layer of high light sensitivity, such that processing and production must take place in a dark-room or under a red lamp.

6. A method as claimed in claim 1, **characterised** in that the light-sensitive layer is selected among gelatin and silver salts having a thickness exceeding 0.2 mm, preferably below 0.5 mm.

7. A method as claimed in claim 1, **characterised** by slightly drying said remaining layer to make it stick to the screen before the substrate is removed by stripping.

0 199 685

Fig. 1

Fig. 2

Fig. 4

Fig. 6

Fig. 7

Fig. 8

_Fig._ 3.

_Fig._ 5